# EUROPEAN PATENT APPLICATION

(11) **EP 4 478 072 A1**
(43) Date of publication of application: **18.12.2024**
(21) Application number: 23178580.9
(22) Date of filing: 12.06.2023
(51) Int. Cl.: G01R 33/28, G01R 33/36

(54) **RADIO FREQUENCY RECEIVER SYSTEM AND METHOD**

(71) Applicant: Koninklijke Philips N.V., 5656 AG Eindhoven (NL)
(72) Inventor: LEUSSLER, Christoph Günther, 5656AG Eindhoven (NL); VERNICKEL, Peter, 5656AG Eindhoven (NL)
(74) Representative: Philips Intellectual Property & Standards

(57) **Abstract**

Cable traps are used inside a magnetic resonance imaging system to protect cables from resonances. These cable traps may have several parasitic resonances in addition to the required resonance frequency for suppressing cable currents. A part of those resonances may exhibit electromagnetic fields extending to the surrounding of a cable trap being sensitive to surrounding material in a characteristic manner which can be harnessed for measurements or detection purposes.

## Description

### FIELD OF THE INVENTION

The invention relates to the field of magnetic resonance imaging. In particular, the present invention relates to a detection system inside a magnetic resonance imaging system using further resonances of a radio frequency (RF) cable trap for monitoring the distance or position of patients and/or objects in a magnetic resonance imaging system. Usually, the RF cable trap has a common mode resonance to suppress common modes that can be excited in the cable conductor. The invention further pertains to a method to prevent patients getting into contact with potentially heated surfaces inside a magnetic resonance imaging system and a corresponding computer implemented method.

### BACKGROUND OF THE INVENTION

Radio frequency induced burns of a patient can occur when a part of the body encounters parts or areas exposed to high electric fields inside a magnetic resonance imaging system and at the same time no sufficient cooling is available. Especially in case parts of the body touch the inner wall of the MR bore, burns can be likely. At such positions there are often high electric fields since the wall is in the vicinity of the RF body coil capacitors.

RF traps can generate a high local electrical field and can become hot in case of resonant coupling and localization. Correct positioning and padding needs guidance and knowledge of the operator to spot the problematic areas for the safe clinical workflow. This situation is still a typical failure mode for reported RF burns.
RF trap or cable heating is the most critical safety concerns in MRI today. Especially sedated patients or children are in danger since they cannot report heating to the operator to manually stop scanning.

A RF trap is a RF resonator, which couples with its lowest mode to the cable. Typically, the electromagnetic field of the lowest mode stays inside the shielded housing. The trap often has also higher EM modes, which are sensitive to tissues or other material, since they have field components outside the trap and can couple with the tissue and/or the higher EM modes can be changed by the object or tissue.

To avoid high currents induced on the coil cables, so-called cable-traps are used which introduce a high impedance for the common mode current on that cable. These currents can be induced via the body coil during transmit pulses. The traps need to be designed without magnetic material to ensure MR-compatibility. They therefore are using resonant structures forming high impedances just at the MRI operating frequency since this is sufficient for the narrow-band pulses.

This resonant tuning can lead to undesired effects, when trap and cable are not placed correctly, or faults and misuse occur: Strong currents are induced in the trap, which potentially lead to critical heating. Further, the required distance to tissue may not be realized. Also, the operator may not conform to all safety rules under stress or in case he is not well trained. Another fault can be caused by a changed position of trap during a scan or the patient table position can change during imaging.
Also, in the case of an unconnected coil, the traps can represent a hazardous risk of skin burns due to EM coupling.

A method to measure a static electric field in the vicinity of a RF cable trap is disclosed in the document ISMRM RF Hardware Recommendations 0.1 2022-03-07. This publication teaches that cable traps can be placed in cable locations that are exposed to high electric fields. The tuning and efficiency of cable traps can be evaluated by using either small, well balanced pick-up loops to scan along the cables, or by using current probes on either side of the cable trap. However, no indication is given to employ the detected field distribution for object or proximity detection or detect changes of electric and/or magnetic fields.

### SUMMARY OF THE INVENTION

It is an object of the invention to provide a detection system which can without much effort measure the position and/or distance of an object in a magnetic resonance imaging system.

According to the invention, this object is addressed by the subject matter of the independent claims. Preferred embodiments of the invention are described in the sub claims.

It is therefore object of the invention to provide a detection system for a magnetic resonance examination system comprising a radio frequency cable trap configured to suppress a common mode resonance of a cable inside the magnetic resonance examination system by resonant absorption at a first RF resonance frequency, a sensor unit configured to detect a magnetic and/or electric field, a controller connected with the sensor unit for control of the sensor unit and a power supply, wherein the radio frequency cable trap is further configured to have a second RF resonance frequency causing a magnetic and/or electric cable trap field in the surrounding of the radio frequency cable trap, and wherein the sensor unit is configured to detect the cable trap field and/or changes in the cable trap field.

For instance, the sensor unit can comprise one or more pickup-probes or antennas for detection of the cable trap field and/or changes in the cable trap field in the surrounding of the radio frequency cable trap. According to the invention, a response of parasitic and/or additional resonances of the RF trap is detected. The cable trap can be a solid structure or can be flexible, like a cable trap. From the detected response of the additional and/or parasitic resonance, the proximity of material like tissue or metal close to the bore wall can be derived. The information on a detected proximity of a patient and/or tissue and/or another object or material near the trap can be communicated to the system host, optionally in a wireless manner. Upon receipt of the detected material near the trap the RF operation of the magnetic resonance examination system may be reduced or interrupted to avoid hazardous situations. In this way, the present invention can contribute to patient safety.

In one embodiment of the invention the second RF resonance frequency is a standard frequency for wireless data transmission. In this way the RF sensing and RF data transmission properties can be combined, and the trap monitoring can be performed by monitoring the signal strength of one or more specific radio frequencies or a certain range.

In another embodiment of the invention the second RF resonance frequency is a wireless LAN or Bluetooth frequency. The trap or the structured antenna can be tailored to resonate at a typical working frequency of WIFI and/or Bluetooth, in particular at 2.4 GHz and/or 5 GHz. Then the trap monitoring can be performed by, for instance, monitoring the signal strength of the WIFI link.

In a further embodiment of the invention the sensor unit is configured to detect a presence and/or distance of material and/or tissue in the surrounding by detection of changes in the cable trap field. The presence detection usually aims to detect a patient that is inside the bore of an MRI system or the distance of a part of a patient's body that is closest to the sensing system.

In another embodiment of the detection system a resonant structure is added to the radio frequency cable trap for tailoring the resonance spectrum of the radio frequency cable trap. To further enhance the sensitivity of the measurement method according to the above-described invention, additional resonant structures can be added to the cable trap, e.g., in a thin patch antenna with certain resonances apart from the Larmor frequency. For this, the sensitive volume can be shaped or tailored by known techniques for antenna design. Wrapped around the original cable trap, it usually does not hamper the primary function of the cable trap and the weight and volume increase is acceptable. Since the main aspect of the invention is that higher mode resonances are disturbed by parasitic loading effects, which can cause a frequency shift and/or a dampening of the resonant mode. Such effects can be detectable already by cheap electronics and the analysis may be refined by using several resonant modes which can be tailored by the proposed added structures. The aforementioned approach using several resonant modes is also known as eigen mode analysis. Local hot spots can be generated by capacitors of the body coil or local transmit coils, producing local electric fields, thus local hot spots. In general, a geometrical distance is required between tissue and surface of inner bore of the body coils. The structured resonant surface as proposed in the invention can also be located on the surface or cover of a local transmit coil used for spectroscopic imaging. Additionally, we can apply the structured resonant surface to surface coil arrays, where critical parts of the coil array are equipped with the proposed structured surface.

In a further realization of the detection system the resonant structure is a resonant antenna of a slot and/or Vivaldi and/or Siretta and/or broadband structured design type. In such a more advanced embodiment of the invention, the native resonator structure of the cable trap is extended by placing additional resonant structures on or close to the cable trap in order to refine the sensing capabilities of the proposed measurement method in the spatial domain, or for distinguishing the kind of material coming - eventually too - close to the trap and therefore enhancing the material sensing sensitivity.

In a further embodiment of the invention the radio frequency cable trap is surrounded or at least partly surrounded by a resonant structure. This facilitates the application of such additional structures which can also be added subsequently or as an option.

In a further embodiment of the invention the resonant structure is a metamaterial. For instance, a structured surface (metamaterial, coupled resonant elements)) integrated on the surface of the trap with resonances in the GHz range which is sensitive to the environment. A metamaterial denotes in general a material engineered to have a property - here one or more characteristics in the RF domain, like a negative refraction index for electromagnetic waves - which is not found in naturally occurring materials. Such metamaterials are often arranged in repeated patterns and at scales which are smaller than the wavelengths of the phenomena they influence. These materials derive their properties usually not from the properties of the base materials, but from their innovative and newly designed structures. Typically, their precise shape, size, geometry, arrangement and orientation gives a metamaterial its smart properties capable of manipulating electromagnetic waves. Such manipulation can comprise blocking, enhancing, absorbing or bending waves for achieving tailored and extended effects which go beyond of those which are possible with conventional materials.

Preferably, a metamaterial with resonance in the GHz range is on the surface of the radio frequency cable trap. This allows an easy installation and/or addition of the relatively complex and often costly metamaterial onto the cable trap.

In a special embodiment of the detection system, the sensor unit and/or controller comprises a data transmission electronics and/or a unique device identification means. This can ensure easy and economic communication means. Also costs and/or cables can therefore be omitted which may disturb the MRI system or which may heat up due to resonances. Furthermore, cheap external modules may be connected in a modular and flexible way.

In another embodiment, the power supply of the detection system uses currents induced by RF frequencies of the radio frequency cable trap and/or magnetic resonance examination system. Then, the detection system takes power wireless from its environment and harnesses the relatively strong electromagnetic field in an MRI system. Hence costs and/or cables can be omitted which may disturb the MRI system or which may heat up due to resonances.

Preferably the detection system is configured to send data to the magnetic resonance examination system. This implies a combination of the RF sensing technology and the RF data transmission properties, and the cable trap monitoring can be realized by monitoring the signal strength of the WIFI link. Thus, the cable trap or the structured antenna are preferably tailored to resonate at a typical working frequency of WIFI or Bluetooth which operate at a frequency of for instance 2.4GHz and/or 5GHz, and/or 60 GHz range.

Detection system according to any of the preceding claims, wherein the detection system is configured to interrupt a scan of the magnetic resonance examination system if a predefined threshold is exceeded. The interruption may prohibit burns and let potential heated parts of the MRI system cool down. An interruption may also be realized by moving the patient away from the potentially hazardous surfaces inside the MRI bore. Hence a repositioning of the patient or moving out of the MRI can be sufficient to indirectly interrupt the scan and/or prevent burns.

The invention also comprises a method for monitoring a position and/or distance of an object - in particular a patient - in a magnetic resonance examination system comprising the steps of: suppressing a common mode resonance of a cable inside the magnetic resonance examination system by resonant absorption at a first RF resonance frequency with a radio frequency cable trap, generating a magnetic and/or electric cable trap field in the surrounding of the radio frequency cable trap with a second RF resonance frequency of the radio frequency cable trap, detecting the cable trap field and/or changes in the cable trap field with a sensor unit and - as a further step - deriving the position and/or distance of the object.

In this way, potentially hazardous situations can be avoided especially for patients which are near heated objects inside the MRI bore, because in case the measured distance is below a certain threshold, measures can be taken to reduce the risk of burns by touching a heated surface. The proposed method can also allow a repositioning of the examined object and/or patient.

The invention also comprises a computer implemented method for monitoring a position and/or distance of an object or patient in a magnetic resonance examination system, comprising the steps: receiving information from a detection system for contactless detecting the position and/or distance of an object and/or a patient in a magnetic resonance examination system, evaluating position and/or distance data, adjusting position of the patient or the object in the magnetic resonance examination system and/or interrupt a scan of the magnetic resonance examination system.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 depicts a detection system according to a preferred embodiment of the invention.
Fig. 2 illustrates a detected change in the cable trap field with a schematic graph of the frequency spectrum before and after placement of an object.
Fig. 3 schematically depicts an antenna placed on a RF cable trap, the antenna for sensing the tissue may (partially) be formed by the RF cable trap's original components itself.
Fig. 4 schematically depicts a second radio frequency antenna system according to a preferred embodiment of the invention with a system integrated body coil with electromagnetic distance sensing.

### DETAILED DESCRIPTION OF EMBODIMENTS

The cable trap 3 - or abbreviated by trap - itself may have several parasitic resonances in addition to the required - one ore even more - resonance frequencies for suppressing cable currents. A part of those resonances may exhibit electromagnetic fields extending to the surrounding of the trap 3 being sensitive to surrounding material in a characteristic manner which can be harnessed for measurements or detection purposes.

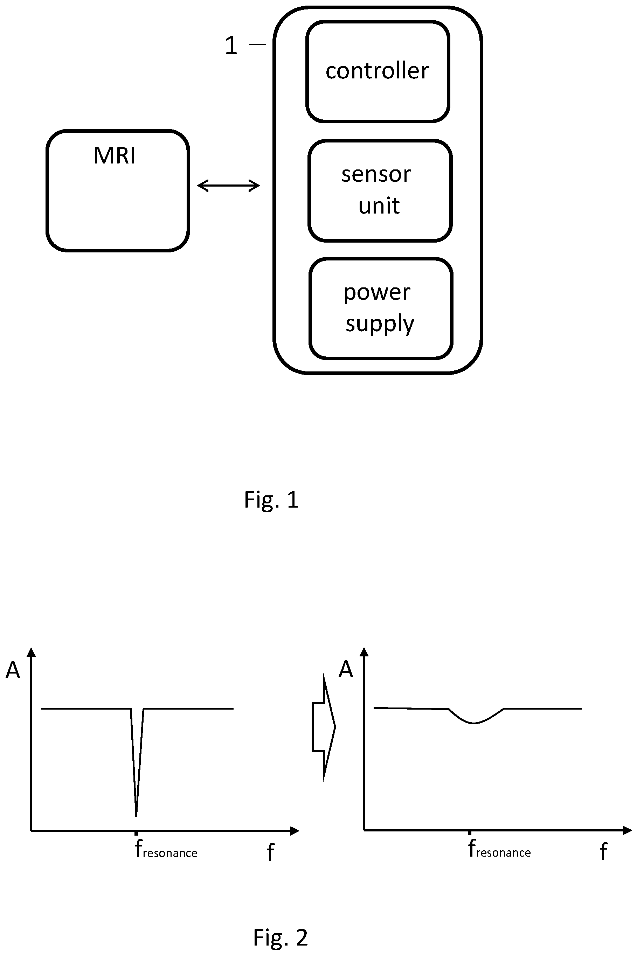

Fig. 1 schematically depicts a radio frequency receiver system 1 according to a preferred embodiment of the invention with a controller 5, a sensor unit 4 and a power supply 6. The detection system 1 is at least partly inside the magnetic resonance examination system 2.

Fig. 2 illustrates a detected change in the RF cable trap 3 field with a schematic graph of the frequency spectrum before and after placement of an object. The RF cable trap 3 itself usually has several parasitic resonances in addition to the demand resonance for suppressing cable currents. A part of those resonances exhibits electromagnetic fields extending to the surrounding of the trap 3. Then those resonances can be sensitive to surrounding material in a characteristic manner. A small pickup probe can be coupled to one end of a RF cable trap 3 for approximately 3T with a functional (current blocking) resonance frequency of 127.8 MHz. A pick-up coil measurement in the left graph of Fig. 2 shows a parasitic resonance f_{R} at approx. 1.4 Ghz, with a significant dip. A pick-up coil measurement usually means an electromagnetic sensor, which can be a loop pick-up coil, a flat ground plane antenna or in general a passive or active electromagnetic sensor usually comprising a semiconductor. When bringing tissue for instance the hand of the experimenter - close to the trap 3 with about 5 mm distance between tissue and metallic parts, the curve shape changes from a steep dip to a broader dip shown in Fig. 2 on the right. A mode at 1.4 GHz is sensitive to tissue loading, where the reflection coefficient and width of bandwidth is a decisive parameter. The frequency is shifted when trap 3 is close to a metallic surface, for instance a rod, rung of birdcage.

The measurements shown in Fig. 2 are performed with a network analyser. However, with recent advancement of microelectronics, the costs suitable electronics for monitoring a trap 3 can be reduced drastically. The required electronic comprises (a) means for power storage, for instance a battery or a capacitor, (b) means for charging like a dedicated power supply or by energy harvesting from existing electromagnetic fields in MR, (c) coupling circuitry to couple to the parasitic modes of the trap 3 which can be realized with a weakly coupling loop or rod antenna and/or a weak capacitive coupling and (d) electronics for measuring RF signals at the frequency of the parasitic modes, which may include a software defined radio (SDR), reflection or transmission measurement and RF pulsed mode. The generator for the test signal at the parasitic mode frequency does not necessarily need to be part of the cable trap 3 since system integrated transmitters, which can be far away from the MRI frequency, are possible. The required electronic further comprises (e) a low power microcontroller for steering the measurement and recognizing out-of-bounds signals and (f) a wireless module for forwarding status messages, e.g. for indicating readiness, and harmful situations by means of WIFI or Bluetooth, ultra-low power Bluetooth (2,4 GHz, 5 GHz), or other data transmission techniques. It is likely that integrated circuits containing most - if not all - functional blocks in one chip/housing are already available on the market.

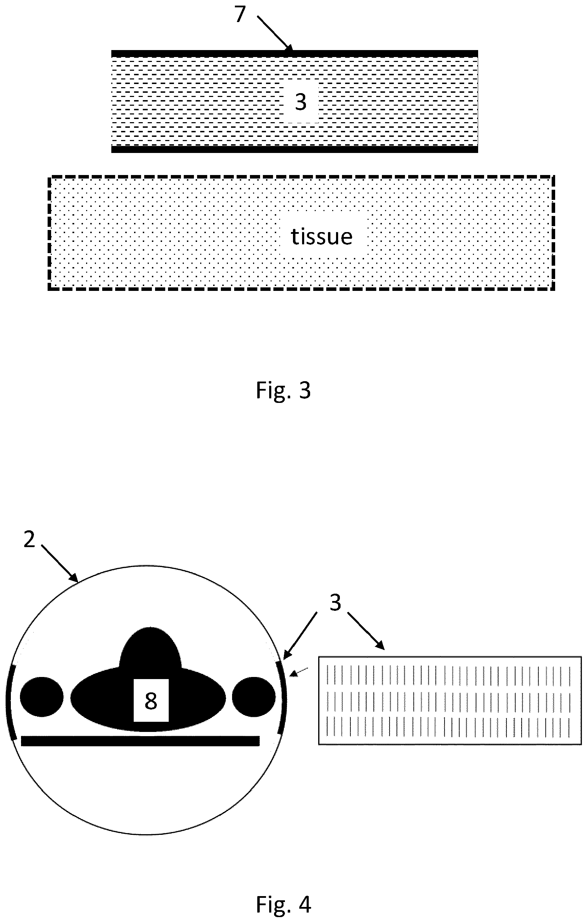

In a more advanced scenario, the native resonator structure of the trap 3 is extended by placing additional resonant structures 7 to refine the sensing capabilities, in the spatial domain, or for distinguishing the kind of material coming (too) close to the trap 3. The RF trap 3 is equipped with a structured antenna (1-5 GHz) on trap 3 design, illustrated in Fig. 3. Different antenna structures can be applied on the surface of the cylindrical trap 3 design as slot antennas, Vivaldi, Siretta, broadband structured designs. Structured surface (metamaterial, coupled resonant elements)) integrated on the surface of the trap 3 resonant in the GHz range is sensitive to the environment.

Instead of just reporting exceeding thresholds, the monitoring device could report its status continuously, especially during patient preparation, to support the workflow routines and to early prevent scan aborts and recalls.

Basically, it is possible to combine the RF sensing technology and the RF data transmission properties which can provide a reliable and low-cost solution. The cable trap 3 or the structured antenna are tailored to resonate at a typical working frequency of WIFI, 5G, or Bluetooth (2.4GHz, 5GHz, 60 GHz). Then the cable trap 3 monitoring can be performed e.g., by monitoring the signal strength of the WIFI link. This value, the RSSI (Received Signal Strength Indicator), is by standard measured as part of the WIFI specification. Comparably low RSSI values indicate antenna loading and can thus be taken as a measure for the distance of the cable trap 3 and tissue.

The RF output of the low power devices can directly be connected to the antenna structures, thus measuring coupling or reflection. Extending this idea further, one could place the distance sensing cable traps 3 at certain locations, even independently of cables, to detect, e.g. body parts directly touching hazardous machine parts. In this way one could detect when e.g. shoulders come too close to parts of the RF body coil. Also, here the idea of structured antennas can be applied instead of sticking to the original shape and parasitic modes of a typical cable trap 3.

Fig. 4 shows a structured surface antenna integrated on the inner bore of the system integrated body coil. The structured surface antenna can also be located on the patient bridge or covers between patient bed and inner cover of the body coil. The structure is located left right in the location of the arms or hands. The resonant distributed structure is transparent for the excitation B 1 field for MRI and the gradient fields. The structured surface consists of coupled resonant structures 7. Injection of the RF is preferably located at the edges of the structure. A pulsed/continuous reflection or transmission measurement is performed and analysed using a SDR transceiver and a trained neuronal network. The analyser can be realized as a standalone system or embedded system using the digital receivers of the MRI system.

### REFERENCE SYMBOL LIST

| | |
|---|---|
| Detection system | 1 |
| Magnetic resonance examination system | 2 |
| Radio frequency (RF) cable trap | 3 |
| Sensor unit | 4 |
| Controller | 5 |
| Power supply | 6 |
| Resonant structure | 7 |

## Claims

1. Detection system (1) for a magnetic resonance examination system (2) comprising
a radio frequency cable trap (3) configured to suppress a common mode resonance of a cable (4) inside the magnetic resonance examination system (2) by resonant absorption at a first RF resonance frequency,
a sensor unit (4) configured to detect a magnetic and/or electric field,
a controller (5) connected with the sensor unit (4) for control of the sensor unit (4) and a power supply (6),
wherein the radio frequency cable trap (3) is further configured to have a second RF resonance frequency causing a magnetic and/or electric cable trap field in the surrounding of the radio frequency cable trap (3), and
wherein the sensor unit (4) is configured to detect the cable trap field and/or changes in the cable trap field.

2. Detection system of claim 1, wherein the second RF resonance frequency is a standard frequency for wireless data transmission.

3. Detection system according to any of the preceding claims, wherein the second RF resonance frequency is a wireless LAN or Bluetooth frequency.

4. Detection system according to any of the preceding claims, wherein the sensor unit (4) is configured to detect a presence and/or distance of material and/or tissue in the surrounding by detection of changes in the cable trap field.

5. Detection system according to any of the preceding claims, wherein a resonant structure (7) is added to the radio frequency cable trap (3) for tailoring the resonance spectrum of the radio frequency cable trap (3).

6. Detection system according to claim 5, wherein the resonant structure (7) is a resonant antenna of a slot and/or Vivaldi and/or Siretta and/or broadband structured design type.

7. Detection system according to claim 5 or 6, wherein the radio frequency cable trap (3) is surrounded or at least partly surrounded by a resonant structure (7).

8. Detection system according to claim 7, wherein the resonant structure (7) is a metamaterial.

9. Detection system according to any of the preceding claims, wherein a metamaterial with resonance in the GHz range is on the surface of the radio frequency cable trap (3).

10. Detection system according to any of the preceding claims, wherein the sensor unit (4) and/or controller (5) comprises a data transmission electronics and/or a unique device identification means.

11. Detection system according to any of the preceding claims, wherein the power supply (6) uses currents induced by RF frequencies of the radio frequency cable trap (3) and/or magnetic resonance examination system (2).

12. Detection system according to any of the preceding claims, wherein the detection system (1) is configured to send data to the magnetic resonance examination system (2).

13. Detection system according to any of the preceding claims, wherein the detection system (1) is configured to interrupt a scan of the magnetic resonance examination system (2) if a predefined threshold is exceeded.

14. Method for monitoring a position and/or distance of an object in a magnetic resonance examination system (2) comprising the steps of
suppressing a common mode resonance of a cable (4) inside the magnetic resonance examination system (2) by resonant absorption at a first RF resonance frequency with a radio frequency cable trap (3),
generating a magnetic and/or electric cable trap field in the surrounding of the radio frequency cable trap (3) with a second RF resonance frequency of the radio frequency cable trap (3),
detecting the cable trap field and/or changes in the cable trap field with a sensor unit (4)
deriving the position and/or distance of the object.

15. Computer implemented method for monitoring a position and/or distance of an object or patient in a magnetic resonance examination system (2), comprising the steps
receiving information from a detection system for contactless detecting the position and/or distance of an object and/or a patient in a magnetic resonance examination system (2),
evaluating position and/or distance data,
adjusting position of the patient or the object in the magnetic resonance examination system (2) and/or
interrupt a scan of the magnetic resonance examination system (2).
